# FASCICULE DE BREVET EUROPEEN

(11) **EP 0 794 622 B1**
(45) Date de publication et mention de la délivrance du brevet: **21.05.2003**
(21) Numéro de dépôt: 97400479.8
(22) Date de dépôt: 03.03.1997
(51) Int. Cl.: H04B 1/30, H03D 11/00

(54) **Récepteurs de signaux radioélectriques à rayonnement réduit**
Funkempfänger mit reduzierter Strahlung
Radio receivers with reduced radiation

(30) Priorité: 04.03.1996 FR 9602675
(43) Date de publication de la demande: 10.09.1997
(73) Titulaire: ATRAL, F-38190 Crolles (FR)
(72) Inventeur: Morey, Gilles, 38330 Saint-Ismier (FR)
(74) Mandataire: Casalonga, Axel

(56) Documents cités:
- GB-A- 2 066 006
- US-A- 5 105 162

## Description

La présente invention concerne les récepteurs de signaux radioélectriques, comprenant une antenne, un oscillateur-détecteur à super-réaction et des moyens pour fixer des périodes composées de séquences de blocage-déblocage de cet oscillateur-détecteur afin de rendre sensible cet oscillateur-détecteur à l'énergie reçue sur une fréquence nominale de réception (f1), ledit oscillateur-détecteur présentant, dans chacune desdites périodes, une phase de sensibilité (A) suivie d'une phase de montée en amplitude ou d'amplitude accrue (B, C) puis de décroissance (D) de ses oscillations.

Par leur simplicité, leur faible coût et leur faible consommation en énergie électrique, de tels récepteurs, associés à des émetteurs émettant des signaux radioélectriques sur leur fréquence nominale, sont utilisés depuis de nombreuses années pour effectuer des liaisons radioélectriques à courtes distances en particulier entre les différents éléments constituant les systèmes d'alarme, de sécurité, ou de domotique, ou de télécommandes diverses en particulier dans le domaine des véhicules automobiles.

Du fait de leur principe de fonctionnement, qui consiste à bloquer et débloquer successivement leur oscillateur-détecteur, de tels récepteurs génèrent une énergie électromagnétique qui peut être rayonnée par leur antenne.

Cette énergie électromagnétique rayonnée rend ainsi difficile la cohabitation proche de deux ou plusieurs récepteurs à oscillateur-détecteur à super-réaction sur la même fréquence nominale ou des fréquences nominales proches, ces récepteurs pouvant s'aveugler mutuellement, ou la cohabitation proche de récepteurs de natures différentes fonctionnant sur une ou des fréquences nominales proches, l'un d'entre eux étant un récepteur à super-réaction.

Une solution apportée à ce jour pour réduire le rayonnement électromagnétique parasite des récepteurs comprenant un oscillateur-détecteur à super-réaction consiste à introduire un ou plusieurs étages amplificateurs montés en tampons entre l'antenne et l'oscillateur-détecteur à super-réaction.

Bien que relativement efficace et permettant en plus d'obtenir une sensibilité accrue de réception, cette solution présente toutefois les inconvénients de rendre ce récepteur à super-réaction plus complexe donc plus coûteux, d'augmenter sa consommation en énergie électrique, de nécessiter éventuellement plusieurs réglages supplémentaires et d'introduire des distorsions par intermodulation fragilisant ce récepteur vis-à-vis de signaux radioélectriques de forte puissance quelle que soit la fréquence et/ou résultant de brouillages volontaires ou involontaires.

Le but de la présente invention est de proposer un récepteur à super-réaction qui permet d'atténuer ou de supprimer les rayonnements parasites d'un tel récepteur.

Le récepteur de signaux radioélectriques selon la présente invention comprend des moyens pour fixer dans chaque période dudit oscillateur-détecteur une première partie (A1), correspondant sensiblement à la phase de sensibilité (A) de cet oscillateur-détecteur, suivie d'une deuxième partie (T) correspondant sensiblement à la phase de montée en amplitude ou d'amplitude accrue (B, C) et de décroissance (D) des oscillations dudit oscillateur-détecteur, et des moyens de couplage/ découplage reliés à l'antenne et/ou audit oscillateur-détecteur, qui couplent au moins partiellement l'antenne à l'oscillateur-détecteur sur la fréquence nominale de réception (f1) pendant ladite première partie (A1) de chacune desdites périodes et qui découplent au moins partiellement l'antenne de l'oscillateur-détecteur sur la fréquence nominale de réception (f1) pendant au moins ladite deuxième partie (T) de chacune desdites périodes, de telle sorte que l'énergie électromagnétique susceptible d'être émise par le récepteur sur ladite fréquence nominale au moins pendant ladite seconde partie (T) de chacune desdites périodes est atténuée ou supprimée.

Le récepteur de signaux radioélectriques selon la présente invention peut présenter les différentes variantes de réalisation préférées suivantes.

Lesdits moyens de couplage/découplage peuvent avantageusement comprendre des moyens de commutation et/ou d'atténuation et/ou d'amplification et/ou de filtrage connectés entre ladite antenne et ledit oscillateur-détecteur et des moyens de commande de ces moyens de commutation et/ou d'atténuation et/ou d'amplification et/ou de filtrage pour, durant chacune desdites périodes, connecter ladite antenne audit oscillateur-détecteur pendant ladite première partie (A1) desdites périodes (21a) et pour au moins partiellement déconnecter ladite antenne dudit oscillateur-détecteur au moins pendant leur deuxième partie (T).

Lesdits moyens de commutation peuvent avantageusement comprendre un commutateur électronique monté entre ladite antenne et ledit oscillateur-détecteur, des moyens pour fermer ce commutateur uniquement pendant ladite première partie (A1) desdites périodes et des moyens pour déconnecter ladite antenne ou pour connecter cette dernière à la masse au moins pendant ladite deuxième partie (T) desdites périodes.

Lesdits moyens de couplage/découplage peuvent avantageusement comprendre des moyens d'atténuation montés entre ladite antenne et ledit oscillateur-détecteur et des moyens de commande de ces moyens d'atténuation pour, durant chacune desdites périodes, connecter ladite antenne audit oscillateur pendant ladite première partie (A1) desdites périodes et pour réduire l'amplitude des signaux pouvant être rayonnés par l'antenne au moins pendant la deuxième partie (T) desdites périodes.

Lesdits moyens de couplage/découplage peuvent avantageusement comprendre un filtre monté entre ladite antenne et ledit oscillateur-récepteur, ce filtre étant accordé pour présenter le minimum de perte ou d'atténuation sur ladite fréquence nominale pendant ladite première partie (A1) desdites périodes et comprenant des moyens pour être accordé sur une autre fréquence pendant ladite seconde partie (T) desdites périodes et présenter le maximum de perte ou d'atténuation sur ladite fréquence nominale pendant cette seconde partie (T).

Lesdits moyens de couplage/découplage peuvent avantageusement comprendre un circuit filtre accordable comprenant en parallèle une self, deux diodes à variation de capacité en opposition et en série, et une capacité, la self étant reliée à l'antenne, le point de liaison entre lesdites diodes étant relié aux moyens fixant lesdites première et deuxième parties et les extrémités de ce circuit étant reliée l'une à la masse et l'autre reliée à l'entrée de l'oscillateur-détecteur.

Lesdits moyens de couplage/découplage peuvent avantageusement comprendre des moyens d'amplification connectés entre l'antenne et l'oscillateur-détecteur et des moyens de commande pour, durant uniquement la première partie desdites séquences, faire fonctionner ces moyens d'amplification de manière à amplifier le signal capté par l'antenne et fournir ce signal amplifié à l'oscillateur-détecteur et pour, durant la seconde partie (T) desdites périodes, déconnecter ces moyens d'amplification.

Lesdits moyens de couplage/découplage peuvent avantageusement comprendre des moyens pour faire osciller ledit oscillateur-récepteur à une fréquence auxiliaire (f2) différente de ladite fréquence nominale de réception (f1) pendant ladite deuxième partie (T) desdites périodes.

Lesdits moyens de couplage/découplage peuvent avantageusement comprendre un filtre fixe, tel qu'un filtre à quartz, à largeur de bande passante inférieure à celle dudit oscillateur-détecteur, accordé sur la fréquence nominale de réception (f1) de cet oscillateur-détecteur.

Lesdits moyens de couplage/découplage peuvent avantageusement comprendre une antenne sélective en fréquence et constituant le filtre précité.

Lesdits moyens de couplage/découplage constituent de préférence, pour le signal à la fréquence nominale de réception et grâçe à un circuit de rétroaction, un circuit atténuateur du niveau du signal reçu à la fréquence nominale (f1) atteignant l'oscillateur-détecteur, commandable ou variable en amplitude, en fréquence ou temporellement en fonction de l'amplitude du signal de sortie basse fréquence, partiellement passant pendant ladite première partie (A1) desdites périodes, constituant ainsi une commande automatique de gain.

Lesdits moyens précités pour fixer dans chaque séquence d'oscillations dudit oscillateur-détecteur ladite première partie suivie de ladite deuxième partie peuvent avantageusement comprendre un monostable dont les deux états déterminent respectivement ces première et deuxième parties, la durée de ces deux états correspondant à la durée desdites séquences de blocage-déblocage dudit oscillateur-détecteur.

La présente invention sera mieux comprise à l'étude de récepteurs de signaux radioélectriques à rayonnement réduit décrits à titre d'exemples non limitatifs et illustrés par le dessin sur lequel :
- la figure 1 représente un schéma d'un récepteur comprenant un oscillateur-détecteur à super-réaction ;
- la figure 2 représente un diagramme de fonctionnement de ce récepteur à super-réaction ;
- la figure 3 représente un premier mode de réalisation d'un récepteur selon la présente invention ;
- la figure 4 représente un second mode de réalisation d'un récepteur selon la présente invention ;
- la figure 5 représente un troisième mode de réalisation d'un récepteur selon la présente invention ;
- la figure 6 représente un quatrième mode de réalisation d'un récepteur selon la présente invention ;
- et la figure 7 représente un cinquième mode de réalisation d'un récepteur selon la présente invention.

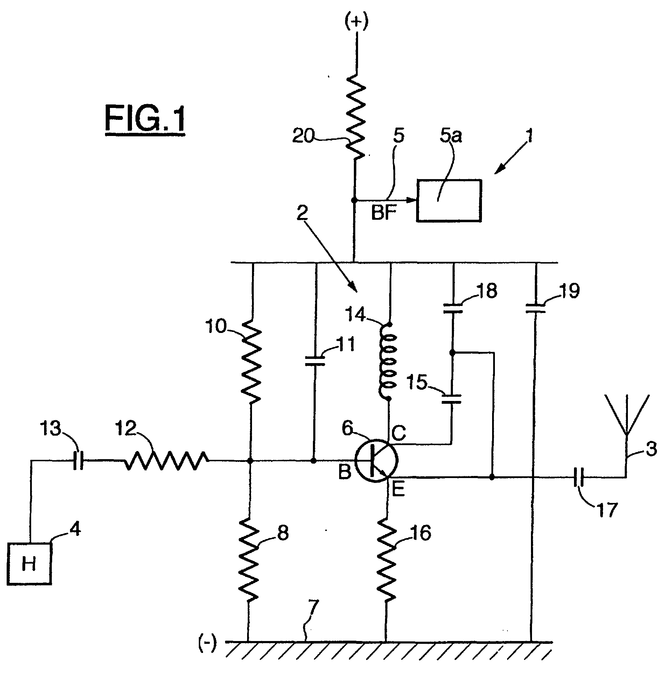

En se reportant à la figure 1, on voit que le récepteur de signaux radioélectriques représenté, repéré d'une manière générale par la référence 1, comprend un oscillateur-détecteur à super-réaction, repéré d'une manière générale par la référence 2, relié à une antenne 3 de réception d'ondes électromagnétiques, recevant des signaux successifs de blocage-déblocage d'une horloge 4 lui permettant d'osciller sur sa fréquence nominale de réception f1 périodiquement pendant des séquences d'oscillations d'une durée déterminée et fournissant sur un point de sortie 5 un signal basse fréquence BF dirigé vers un organe de traitement 5a.

Dans l'exemple représenté, l'oscillateur-détecteur 2 comprend un élément actif constitué par un transistor 6 dont la base est reliée au pôle (-) d'une alimentation ou masse 7 par l'intermédiaire d'une résistance 8, au point 5 via une résistance 10 et une capacité 11 en parallèle, et à l'horloge 4 via une résistance 12 et une capacité 13 en série.

Le collecteur du transistor 6 est relié au point 5 par l'intermédiaire d'une self 14 constituant un élément réactif, et à son émetteur par l'intermédiaire d'une capacité de réaction 15.

L'émetteur du transistor 6 est relié au pôle (-) via une résistance 16, à l'antenne 3 via une capacité 17 et au point 5 par une capacité 18 d'adaptation d'impédance.

Une capactité de filtrage 19 relie le point 5 à la masse 7.

Le point 5 est relié au pôle (+) de l'alimentation au travers d'une résistance 20, la détection de la modulation basse fréquence (BF) se faisant par extraction de la variation du courant moyen consommé par l'étage oscillateur-détecteur 2.

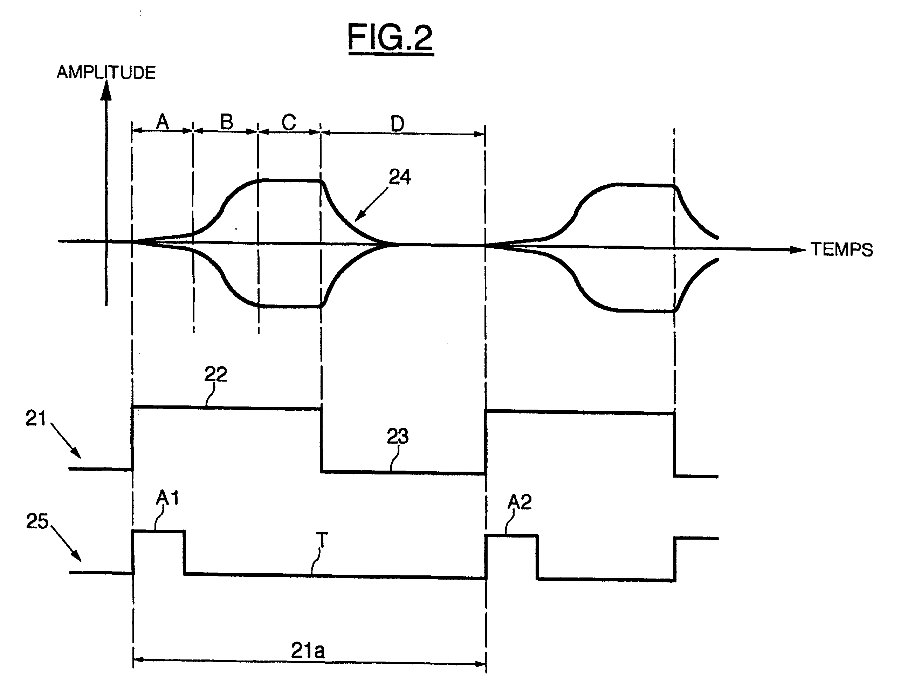

En se reportant à la figure 2 on voit qu'on a représenté un diagramme général de fonctionnement du récepteur 1 de la figure 1.

Sur cette figure 2, on voit qu'on a représenté la forme d'un signal de commande en créneaux 21 déterminant des périodes 21a de blocage-déblocage de l'oscillateur-détecteur 2. Ce signal est fourni par l'horloge 4 qui fixe dans chaque période 21a, cycliquement, des séquences de déblocage 22 suivies de séquences de blocage 23 de cet oscillateur-détecteur 2.

En correspondance avec le signal d'horloge 21, on a également représenté sur la figure 2 une courbe enveloppe particulière, répérée d'une manière générale par la référence 24, de l'amplitude des oscillations de l'oscillateur-détecteur 2 en mode de détection dit logarithmique.

On voit que cette courbe 24 comprend dans chaque séquence de déblocage 22 de l'oscillateur-détecteur 2 une phase A de sensibilité, suivie d'une phase B de croissance de l'amplitude des oscillations de l'oscillateur-détecteur 2, suivie d'une phase C de stabilisation de cette amplitude et suivie, dans la séquence de blocage 23, d'une phase D de chute ou de décroissance progressive et rapide de cette amplitude. La phase C pourrait ne pas exister et, en un mode de détection dit linéaire non représenté, la phase D interviendrait avant la fin de la phase B.

On voit sur la figure 2 qu'on a également représenté un signal de commande 25 dont la durée correspond à la période 21a précitée et qui comprend une première partie A1 qui correspond sensiblement à la phase de sensibilité A précitée de l'oscillateur-détecteur 2, suivie d'une deuxième partie T. Ainsi, cette deuxième partie T recouvre les phases B, C et D précitées d'amplitude accrue des oscillations de l'oscillateur-détecteur 2. Dans l'exemple représenté, la première partie A1 est plus courte que la phase de senbsibilité A

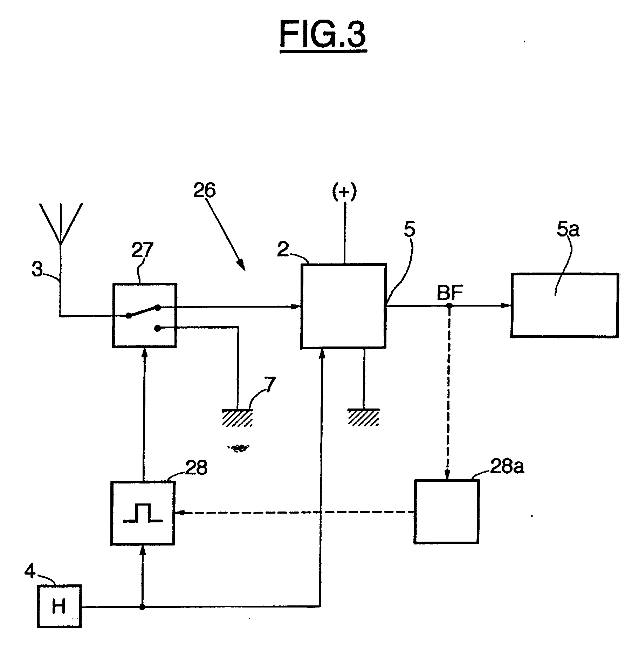

En se reportant maintenant à la figure 3, on voit qu'on a représenté un récepteur 26 qui correspond au récepteur 1 décrit en référence à la figure 1 mais qui comprend en outre, entre l'oscillateur-détecteur 2 et l'antenne 3 un interrupteur ou commutateur électronique de couplage-découplage portant la référence 27. Ce commutateur 27 est commandé par un circuit monostable 28 séquencé par l'horloge 4 et dont les deux états déterminent respectivement les phases A1 et T précitées.

Ce récepteur 26 fonctionne de la manière suivante.

Sur le front montant du signal d'horloge 21 correspondant au début de la séquence de déblocage 22 de l'oscillateur-détecteur 2, le monostable 28 s'enclenche pendant une durée déterminée correspondant à la première partie A1 précitée et commande le commutateur 27 pendant cette durée de façon à coupler ou relier l'antenne 3 à l'oscillateur-détecteur 2. Puis, au bout de la durée de cette première partie A1, le monostable 28 se déclenche et commande le commutateur 27 de façon à, pendant la phase T précitée se terminant à la fin de la période 21a précitée, découpler l'oscillateur-détecteur 2 et relier cette antenne 3 à la masse 7.

Ainsi, du fait que l'antenne 3 n'est reliée à l'oscillateur-détecteur 2 que pendant la phase de sensibilité A située au début de chaque séquence de déblocage 22 de cet oscillateur-détecteur, le récepteur 26 ne peut rayonner ou émettre aucune énergie électromagnétique par son antenne 3 en dehors de sa phase de sensibilité A, étant noté que le rayonnement électromagnétique produit pendant cette phase de sensibilité A est très faible et donc non nuisible du fait que l'amplitude des oscillations de l'oscillateur-détecteur 2 pendant cette phase de sensibilité A est faible.

Il s'ensuit que le récepteur 26 ne peut fournir aucune énergie à son antenne 3 et ne produit en conséquence aucun rayonnement électromagnétique par son antenne 3 qui pourrait être dû aux phases d'amplitude accrue des oscillations de l'oscillateur-détecteur 2 pendant les phases B, C et D précitées.

Dans une variante, la sortie basse fréquence (BF) 5 pourrait être reliée au monostable 28 par l'intermédiaire d'un circuit de rétroaction 28a permettant de faire varier la durée de la première partie A1 ou la position temporelle de cette première partie par rapport à la phase de sensibilité A de l'oscillateur-détecteur au cours de la période 21a afin d'atténuer plus ou moins le signal à la fréquence nominale délivré par l'antenne vers l'oscillateur-détecteur.

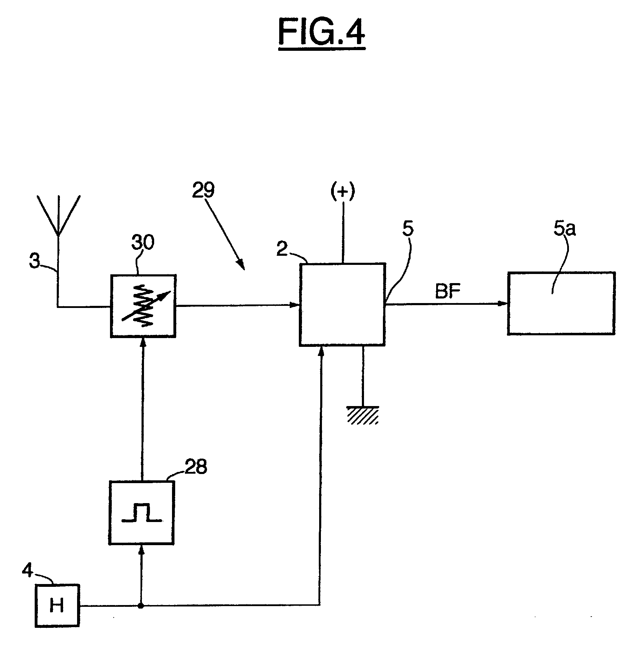

Dans le récepteur 29 représenté sur la figure 4, le commutateur 27 du récepteur 26 décrit en référence à la figure 3 est remplacé par un circuit d'atténuation commandé 30 qui, sous l'impulsion du monostable 28 pendant la phase de sensibilité A précitée, couple l'oscillateur-détecteur 2 et l'antenne 3. Par contre, en dehors de cette phase A, ce circuit d'atténuation 30 découple l'oscillateur-détecteur 2 et l'antenne 3 en atténuant, par exemple en engendrant des pertes, l'amplitude du signal le traversant dans des proportions qui peuvent être importantes.

Ainsi, l'amplitude du signal que l'oscillateur-détecteur 2 envoie au circuit d'atténuation 30 en dehors de cette phase A subit une forte réduction avant d'atteindre l'antenne 3, de telle sorte que le rayonnement électromagnétique qui en résulte est faible.

Dans une exécution simple, le circuit d'atténuation 30 pourrait être constitué par une diode ou une combinaison de diodes P.I.N. dont l'impédance aux fréquences radioélectriques varie en fonction du courant de polarisation.

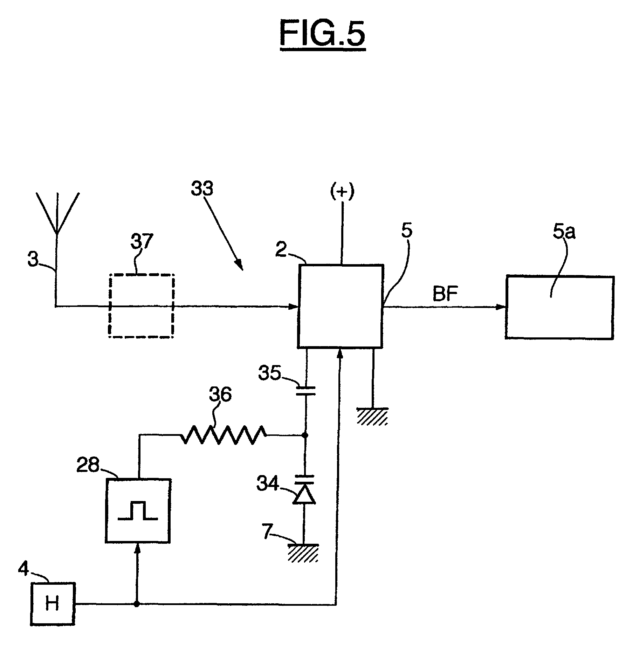

En se reportant maintenant à la figure 5, on voit qu'on a représenté un récepteur 33 constituant un autre mode de réalisation du couplage/découplage, sur la fréquence nominale de réception, de l'antenne 3 et de l'oscillateur-détecteur 2 des récepteurs décrits en référence aux figures 3 et 4.

Ce récepteur 33 est susceptible de faire fonctionner l'oscillateur-détecteur 2 à sa fréquence nominale de réception f1 pendant la phase de sensibilité A précitée et de le faire osciller à une fréquence f2 différente en dehors de cette phase de sensibilité A, pendant les phases B, C et D précitées.

Pour celà, une diode 34 à variation de capacité et une capacité 35 sont montées en série entre la masse 7 et le collecteur du transistor 6 de l'oscillateur-détecteur 2 et la sortie du monostable 28 est connectée à la liaison entre cette diode 34 et cette capacité 35 via une résistance 36. Tout autre moyen pourrait être utilisé pour modifier cette fréquence d'oscillations, par exemple en modifiant la polarité de l'oscillateur-détecteur 2.

Il s'ensuit que, dans cet exemple de la figure 5, l'énergie électromagnétique émise par l'antenne 3 et générée par l'oscillateur-détecteur 2 pendant les phases B, C et D précitées se produit sur une fréquence f2 différente de la fréquence nominale de réception f1 de cet oscillateur-détecteur 2. En conséquence, le canal radioélectrique associé à la fréquence f1 n'est pas perturbé par l'énergie électromagnétique émise par l'antenne 3 pendant les phases d'oscillations à amplitude accrue de l'oscillateur-détecteur 2.

Dans une variante d'exécution représentée en pointillés sur la figure 5, un filtre de fréquence fixe 37, accordé sur la fréquence nominale de réception f1, peut être monté entre l'antenne 3 et l'oscillateur-détecteur 2 afin d'atténuer le rayonnement électromagnétique ou l'énergie radioélectrique émise par l'antenne 3 sur la fréquence modifiée f2.

Dans une autre variante, le filtre 37 pourrait être un filtre fixe à largeur de bande passante inférieure à celle de l'oscillateur-détecteur 2, accordé sur la fréquence nominale f1 de réception de cet oscillateur-détecteur, et de préférence un filtre par exemple à quartz présentant une largeur de bande passante très étroite, étant entendu qu'un tel filtre, à fort coefficient de surtension, est susceptible d'emmagasiner de l'énergie pour la restituer ultérieurement.

Dans ce schéma cependant, par la combinaison de la modification de la fréquence de fonctionnement de l'oscillateur-détecteur 2, passant de la fréquence f1 à la fréquence f2, et de la largeur de bande passante très étroite de ce filtre à quartz 37, accordé sur la fréquence f1, ce filtre à quartz 37 n'est pas en mesure d'emmagasiner d'énergie pendant les phases d'oscillation à amplitude accrue de l'oscillateur-détecteur 2 et donc ne restitue aucune énergie pendant la phase de sensibilité A2 suivante de l'oscillateur-détecteur 2.

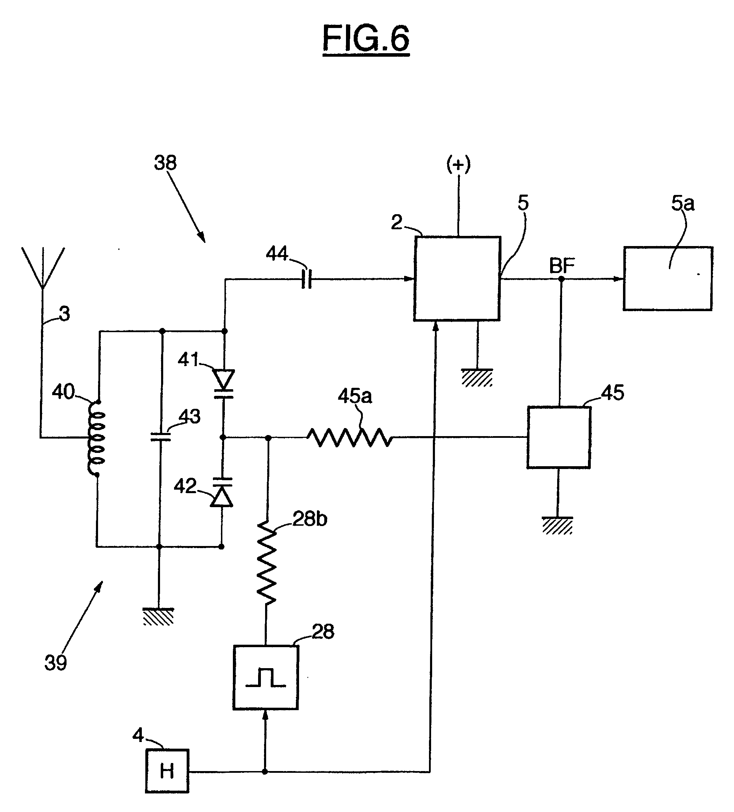

Dans la variante de la figure 6, le récepteur 38 représenté, qui correspond à une exécution différente du récepteur 33 décrit en référence à la figure 5, comprend, en vue du couplage/découplage de l'antenne 3 et de l'oscillateur-détecteur 2, un circuit filtre accordable 39 commandé par le monostable 28 et placé entre l'antenne 3 et l'oscillateur-détecteur 2, ce circuit 39 étant accordé sur la fréquence nominale de réception f1 pendant la première partie A1 précitée et sur une autre fréquence f2 en dehors de cette première partie A1, pendant les phases B, C et D précitées.

Pour celà, le circuit 39 comprend, en parallèle, d'une part une self 40, deux diodes à variation de capacité 41 et 42 en opposition et en série, et une capacité d'accord 43. La self 40 est reliée à l'antenne 3 par un branchement intermédiaire, le point de liaison entre les diodes 41 et 42 est relié au monostable 28 via une résistance 28b et les extrémités de ce circuit sont l'une à la masse et l'autre reliée à l'entrée de l'oscillateur-détecteur 2 via une capacité 44.

En outre, la sortie basse fréquence (BF) 5 de l'oscillateur-détecteur 2 est reliée à l'entrée d'un étage de contre-réaction 45 dont la sortie est reliée au point de liaison entre les diodes 41 et 42 via une résistance 45a. Cet étage de contre-réaction 45 produit à sa sortie une tension proportionnelle à la tension crête du signal basse fréquence (BF) détectée et filtrée, réalisant ainsi la fonction de commande automatique de gain (CAG) en désaccordant en fréquence, plus ou moins, le filtre accordé 39 par rapport à la fréquence nominale f1 et pendant la première partie A1 de la période 21a.

Ainsi, le circuit 39 est accordé sur la fréquence nominale de réception f1 sous l'impulsion du monostable 28 associée à la première partie A1 pour présenter le minimum de perte ou d'atténuation sur cette fréquence nominale et est accordé sur une autre fréquence f2 en dehors de cette première partie A1 pour présenter le maximum de perte ou d'atténuation sur ladite fréquence nominale pendant cette seconde partie, supprimant en conséquence au moins partiellement tout rayonnement électromagnétique par l'antenne 3 pendant les phases B, C, et D précitées.

Le circuit 39 réalise ainsi les fonctions d'adaptation d'impédance entre l'antenne 3 et l'oscillateur-détecteur 2, de filtre d'antenne radiofréquence, de commande automatique de gain (CAG) et de suppression des rayonnements radioélectriques indésirables de l'oscillateur-détecteur 2.

Dans une variante de la figure 6, l'antenne 3 et la self 40 pourraient être constituées en particulier par un cadre accordé réalisé sur un circuit imprimé, ce cadre constituant ainsi en même temps une antenne, un filtre, et remplissant la fonction de commande automatique de gain (CAG) et éventuellement d'adaptation d'impédance.

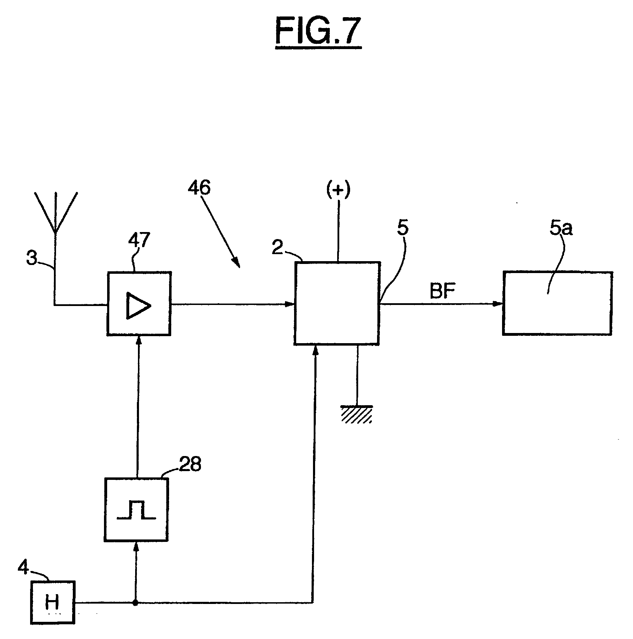

En se reportant maintenant à la figure 7, on voit qu'on a représenté un récepteur 46 constituant un autre mode de réalisation du couplage/découplage, sur la fréquence nominale de réception, de l'antenne 3 et de l'oscillateur-détecteur 2. Dans cet exemple, l'antenne 3 est connectée à l'oscillateur-détecteur 2 par l'intermédiaire d'un circuit d'amplification 47.

Ce circuit d'amplification, sous l'impulsion du monostable 28 associée en durée à la première partie A1 précitée, amplifie le signal capté par l'antenne et fournit ce signal amplifié à l'oscillateur-détecteur 2, tandis qu'en dehors de cette première partie A1, il est déconnecté, c'est-à-dire qu'aucun signal reçu par l'antenne 3 n'est transmis à l'oscillateur-détecteur 2.

Cette variante de la figure 7 permet d'obtenir un récepteur qui est très sensible à des signaux électromagnétiques de faibles amplitudes, qui ne rayonne pas et qui, de plus, est peu consommateur d'énergie électrique.

Dans une exécution simple, l'amplificateur 47 pourrait être constitué par un étage à un ou plusieurs transistors ou circuits intégrés d'amplification radiofréquence.

La présente invention ne se limite pas aux exemples ci-dessus décrits. Bien des variantes pour réaliser un récepteur à super-réaction à rayonnement réduit, notamment par combinaison des exemples décrits précédemment, sont possibles sans sortir du cadre défini par les revendications annexées. En particulier, le récepteur à super-réaction pourrait être du type à horloge de séquencement ou d'échantillonnage intégrée (auto-quench).

## Revendications

1. Récepteur de signaux radioélectriques, comprenant une antenne (3), un oscillateur-détecteur (2) à super-réaction et des moyens (4) pour fixer des périodes (21a) composées de séquences de blocage-déblocage (23, 22) de cet oscillateur-détecteur afin de rendre sensible cet oscillateur-détecteur à l'énergie reçue sur une fréquence nominale de réception (f1), ledit oscillateur-détecteur présentant, dans chacune desdites périodes (21a), une phase de sensibilité (A) suivie d'une phase de montée en amplitude ou d'amplitude accrue (B, C) puis de décroissance (D) de ses oscillations,
**caractérisé par le fait qu'**il comprend des moyens (28) pour fixer dans chaque période (21a) dudit oscillateur-détecteur une première partie (A1), correspondant sensiblement à la phase de sensibilité (A) de cet oscillateur-détecteur, suivie d'une deuxième partie (T) correspondant sensiblement à la phase de montée en amplitude ou d'amplitude accrue (B, C) et de décroissance (D) des oscillations dudit oscillateur-détecteur, et des moyens (27 ; 30 ; 34, 37 ; 39 ; 47) de couplage/découplage reliés à l'antenne (3) et/ou audit oscillateur-détecteur (2), qui couplent au moins partiellement l'antenne à l'oscillateur-détecteur sur la fréquence nominale de réception (f1) pendant ladite première partie (A1) de chacune desdites périodes (21a) et qui découplent au moins partiellement l'antenne (3) de l'oscillateur-détecteur (2) sur la fréquence nominale de réception (f1) pendant au moins ladite deuxième partie (T) de chacune desdites périodes (21a), de telle sorte que l'énergie électromagnétique susceptible d'être émise par le récepteur sur ladite fréquence nominale au moins pendant ladite seconde partie (T) de chacune desdites périodes (21a) est atténuée ou supprimée.

2. Récepteur selon la revendication 1, **caractérisé par le fait que** lesdits moyens de couplage/découplage comprennent des moyens de commutation et/ou d'atténuation et/ou d'amplification et/ou de filtrage connectés entre ladite antenne et ledit oscillateur-détecteur et des moyens de commande de ces moyens de commutation et/ou d'atténuation et/ou d'amplification et/ou de filtrage pour, durant chacune desdites périodes (21a), connecter ladite antenne (3) audit oscillateur-détecteur (2) pendant ladite première partie (A1) desdites périodes (21a) et pour au moins partiellement déconnecter ladite antenne (3) dudit oscillateur-détecteur (2) au moins pendant leur deuxième partie (T).

3. Récepteur selon la revendication 2, **caractérisé par le fait que** lesdits moyens de commutation comprennent un commutateur électronique (27) monté entre ladite antenne (3) et ledit oscillateur-détecteur (2), des moyens (4, 28) pour fermer ce commutateur uniquement pendant ladite première partie (A1) desdites périodes (21a) et des moyens pour déconnecter ladite antenne ou pour connecter cette dernière à la masse au moins pendant ladite deuxième partie (T) desdites périodes (21a).

4. Récepteur selon l'une des revendications 1 et 2, **caractérisé par le fait que** lesdits moyens de couplage/découplage comprennent des moyens d'atténuation (30) montés entre ladite antenne (3) et ledit oscillateur-détecteur (2) et des moyens de commande de ces moyens d'atténuation pour, durant chacune desdites périodes (21a), connecter ladite antenne audit oscillateur pendant ladite première partie (A1) desdites périodes (21a) et pour réduire l'amplitude des signaux pouvant être rayonnés par l'antenne au moins pendant la deuxième partie (T) desdites périodes (21a).

5. Récepteur selon l'une des revendications 1 et 2, **caractérisé par le fait que** lesdits moyens de couplage/découplage comprennent un filtre (39) monté entre ladite antenne et ledit oscillateur-récepteur, ce filtre étant accordé pour présenter le minimum de perte ou d'atténuation sur ladite fréquence nominale pendant ladite première partie (A1) desdites périodes (21a) et comprenant des moyens pour être accordé sur une autre fréquence pendant ladite seconde partie (T) desdites périodes (21a) et présenter le maximum de perte ou d'atténuation sur ladite fréquence nominale pendant cette seconde partie (T).

6. Récepteur selon la revendication 5, **caractérisé par le fait que** le dit filtre accordable (39) comprend en parallèle une self, deux diodes à variation de capacité (41, 42) en opposition et en série, et une capacité (43), la self étant reliée à l'antenne, le point de liaison entre lesdites diodes étant relié aux moyens (28) fixant lesdites première et deuxième parties (28) et les extrémités de ce circuit étant reliée l'une à la masse et l'autre reliée à l'entrée de l'oscillateur-détecteur.

7. Récepteur selon l'une des revendications 1 et 2, **caractérisé par le fait que** lesdits moyens de couplage/découplage comprennent des moyens d'amplification (47) connectés entre l'antenne (3) et l'oscillateur-détecteur (2) et des moyens de commande pour, durant uniquement la première partie desdites séquences, faire fonctionner ces moyens d'amplification de manière à amplifier le signal capté par l'antenne et fournir ce signal amplifié à l'oscillateur-détecteur et pour, durant la seconde partie (T) desdites périodes (21a), déconnecter ces moyens d'amplification.

8. Récepteur selon l'une quelconque des revendications 1 et 2, **caractérisé par le fait que** lesdits moyens de couplage/découplage comprennent des moyens (34, 35, 36) pour faire osciller ledit oscillateur-récepteur à une fréquence auxiliaire (f2) différente de ladite fréquence nominale de réception (f1) pendant ladite deuxième partie (T) desdites périodes (21a).

9. Récepteur selon la revendication 8, **caractérisé par le fait que** lesdits moyens de couplage/découplage comprennent un filtre fixe (37), tel qu'un filtre à quartz, à largeur de bande passante inférieure à celle dudit oscillateur-détecteur, accordé sur la fréquence nominale de réception (f1) de cet oscillateur-détecteur.

10. Récepteur selon la revendication 9, **caractérisé par le fait que** lesdits moyens de couplage/découplage comprennent une antenne sélective en fréquence et constituant le filtre précité.

11. Récepteur selon l'une quelconque des revendications 3 et 6, **caractérisé par le fait que** lesdits moyens de couplage/découplage constituent, pour le signal à la fréquence nominale de réception et grâçe à un circuit de rétroaction, un circuit atténuateur du niveau du signal reçu à la fréquence nominale f1 atteignant l'oscillateur-détecteur, commandable ou variable en amplitude, en fréquence ou temporellement en fonction de l'amplitude du signal de sortie basse fréquence, partiellement passant pendant ladite première partie (A1) desdites périodes (21a), constituant ainsi une commande automatique de gain.

12. Récepteur selon l'une quelconque des revendications précédentes, **caractérisé par le fait que** lesdits moyens précités (28) pour fixer dans chacune desdites périodes (21a) dudit oscillateur-détecteur ladite première partie (A1) suivie de ladite deuxième partie (T) comprennent un monostable (28) dont les deux états (A1, T) déterminent respectivement ces première et deuxième parties.

## Claims

1. Radio signal receiver, comprising an antenna (3), a super-reaction oscillator-detector (2) and means (4) for setting periods (21a) consisting of on-off sequences (23, 22) for this oscillator-detector in order to make this oscillator-detector sensitive to the power received at a nominal receiving frequency (f1), the said oscillator-detector having, in each of the said periods (21a), a sensitive phase (A) followed by a phase of increasing amplitude or of high amplitude (B, C) then of decay (D) of its oscillations, **characterized in that** it comprises means (28) for setting, in each period (21a) of the said oscillator-detector, a first part (A1), corresponding substantially to the sensitive phase (A) of this oscillator-detector, followed by a second part (T) corresponding substantially to the phase of increasing amplitude or of high amplitude (B, C) and of decay (D) of the oscillations of the said oscillator-detector, and coupling/uncoupling means (27; 30; 34, 37; 39; 47) connected to the antenna (3) and/or to the said oscillator-detector (2), which at least partially couple the antenna to the oscillator-detector at the nominal receiving frequency (f1) during the said first part (A1) of each of the said periods (21a) and which at least partially uncouple the antenna (3) of the oscillator-detector (2) at the nominal receiving frequency (f1) for at least the said second part (T) of each of the said periods (21a), such that the electromagnetic power likely to be emitted by the receiver at the said nominal frequency at least during the said second part (T) of each of the said periods (21a) is attenuated or cut off.

2. Receiver according to Claim 1, **characterized in that** the said coupling/uncoupling means comprise switching and/or attenuation and/or amplification and/or filtering means connected between the said antenna and the said oscillator-detector and means for controlling these switching and/or attenuation and/or amplification and/or filtering means in order, during each of the said periods (21a), to connect the said antenna (3) to the said oscillator-detector (2) during the said first part (A1) of the said periods (21a) and in order to at least partially disconnect the said antenna (3) from the said oscillator-detector (3) at least during their second part (T).

3. Receiver according to Claim 2, **characterized in that** the said switching means comprise an electronic switch (27) mounted between the said antenna (3) and the said oscillator-detector (2), means (4, 28) to close this switch only during the said first part (A1) of the said periods (21a) and means for disconnecting the said antenna or for connecting the latter to earth at least during the said second part (T) of the said periods (21a).

4. Receiver according to either of Claims 1 and 2, **characterized in that** the said coupling/uncoupling means comprise attenuation means (30) mounted between the said antenna (3) and the said oscillator-detector (2) and means for controlling these attenuation means in order, during each of the said periods (21a), to connect the said antenna to the said oscillator during the said first part (A1) of the said periods (21a) and in order to reduce the amplitude of the signals which can be radiated by the antenna at least during the second part (T) of the said periods (21a).

5. Receiver according to either of Claims 1 and 2, **characterized in that** the said coupling/uncoupling means comprise a filter (39) mounted between the said antenna and the said oscillator-receiver, this filter being tuned in order the exhibit minimum losses or attenuation at the said nominal frequency during the said first part (A1) of the said periods (21a) and comprising means for being tuned to another frequency during the said second part (T) of the said periods (21a) and exhibiting maximum losses or attenuation at the said nominal frequency during this second part (T).

6. Receiver according to Claim 5, **characterized in that** the said tuneable filter (39) comprises an inductor in parallel, two variable-capacitance diodes (41, 42) in opposition and in series, and a capacitor (43), the inductor being connected to the antenna, the connection point between the said diodes being connected to the means (28) setting the said first and second parts (28) and one end of this circuit being connected to earth and the other end being connected to the input of the oscillator-detector.

7. Receiver according to either of Claims 1 and 2, **characterized in that** the said coupling/uncoupling means comprise amplification means (47) connected between the antenna (3) and the oscillator-detector (2) and control means in order, solely during the first part of the said sequences, to operate these amplification means so as to amplify the signal picked up by the antenna and to supply this amplified signal to the oscillator-detector and in order, during the second part (T) of the said periods (21a), to disconnect these amplification means.

8. Receiver according to either of Claims 1 and 2, **characterized in that** the said coupling/uncoupling means comprise means (34, 35, 36) for making the said oscillator-receiver oscillate at an additional frequency (f2) different from the said nominal receiving frequency (f1) during the said second part (T) of the said periods (21a).

9. Receiver according to Claim 8, **characterized in that** the said coupling/uncoupling means comprise a fixed filter (37), such as a quartz filter, with a band width less than that of the said oscillator-detector, tuned to the nominal receiving frequency (f1) of this oscillator-detector.

10. Receiver according to Claim 9, **characterized in that** the said coupling/uncoupling means comprise a frequency-selective antenna forming the aforementioned filter.

11. Receiver according to any one of Claims 3 and 6, **characterized in that** the said coupling/uncoupling means form, for the signal at the nominal receiving frequency and by virtue of a feedback circuit, an attenuating circuit which attenuates the signal received at the nominal frequency f1 reaching the oscillator-detector, which can be controlled or varied according to amplitude, frequency, or temporally as a function of the amplitude of the low-frequency output signal, which is partially on during the said first part (A1) of the said periods (21a), thus forming an automatic gain control.

12. Receiver according to any one of the preceding claims, **characterized in that** the said aforementioned means (28) for setting, in each of the said periods (21a) of the said oscillator-detector, the said first part (A1) followed by the said second part (T) comprise a monostable multivibrator (28) whose two states (A1, T) determine the first and second parts, respectively.

## Patentansprüche

1. Funkempfänger mit einer Antenne (3), einem Oszillator-Detektor (2) mit Rückkopplung und Mitteln (4) zum Bestimmen von Perioden (21a), die aus Sequenzen Blockierung-Freigabe (23, 22) dieses Oszillator-Detektors zusammengesetzt sind, um diesen Oszillator-Detektor auf die auf einer Nominalempfangsfrequenz (f1) empfangene Energie empfindlich zu machen, welcher Oszillator-Detektor in jeder der Perioden (21a) eine Empfindlichkeitsphase (A), gefolgt von einer Phase mit Amplitudenanstieg oder angewachsener Amplitude (B, C), anschließend des Abfalls (D) seiner Oszillationen aufweist,
**dadurch gekennzeichnet, dass** er Mittel (28) zum Bestimmen in jeder Periode (21a) des Oszillator-Detektors eines ersten Teils (A1), der im wesentlichen der Empfindlichkeitsphase (A) dieses Oszillator-Detektors entspricht, gefolgt von einem zweiten Teil (T), der im wesentlichen der Phase mit Amplitudenanstieg oder angewachsener Amplitude (B, C) und des Abfalls (D) der Oszillationen des Oszillator-Detektors entspricht, und mit der Antenne (3) und/oder dem Oszillator-Detektor (2) verbundene Kopplungs-/Entkopplungsmittel (27; 30; 34, 37; 39; 47) umfasst, die wenigstens teilweise die Antenne mit dem Oszillator-Detektor auf der Empfangsnominalfrequenz (f1) während des ersten Teils (A1) jeder der Perioden (21a) koppeln und die wenigstens teilweise die Antenne (3) von dem Oszillator-Detektor (2) auf der Empfangsnominalfrequenz (f1) während wenigstens des zweiten Teils (T) jeder der Perioden (21a) entkoppeln, derart, dass die elektromagnetische Energie, die von dem Empfänger auf der Nominalfrequenz wenigstens während des zweiten Teils (T) jeder der Perioden (21a) emittiert werden kann, gedämpft oder unterdrückt wird.

2. Empfänger nach Anspruch 1, **dadurch gekennzeichnet, dass** die Kopplungs-/Entkopplungsmittel Mittel zur Kommutation und/oder Dämpfung und/oder Verstärkung und/oder Filterung, die zwischen der Antenne und dem Oszillator-Detektor angeschlossen sind, und Mittel zur Steuerung dieser Mittel zur Kommutation und/oder Dämpfung und/oder Verstärkung und/oder Filterung umfassen, um, während jeder der Perioden (21a), die Antenne (3) mit dem Oszillator-Detektor (2) während des ersten Teils (A1) der Perioden (21a) zu verbinden, und um die Antenne (3) wenigstens während ihres zweiten Teils (T) wenigstens teilweise von dem Oszillator-Detektor (2) zu trennen.

3. Empfänger nach Anspruch 2, **dadurch gekennzeichnet, dass** die Kommutationsmittel einen zwischen die Antenne (3) und den Oszillator-Detektor (2) montierten elektronischen Kommutator (27), Mittel (4, 28) zum Schließen dieses Kommutators nur während des ersten Teils (A1) der Perioden (21a), und Mittel zum Trennen der Antenne oder zum Verbinden der letzteren mit der Masse wenigstens während des zweiten Teils (T) der Perioden (21a) umfassen.

4. Empfänger nach einem der Ansprüche 1 und 2, **dadurch gekennzeichnet, dass** die Kopplungs-/Entkopplungsmittel zwischen die Antenne (3) und den Oszillator-Detektor (2) montierte Dämpfungsmittel (30) und Mittel zur Steuerung dieser Dämpfungsmittel umfassen, um während jeder der Perioden (21a) die Antenne mit dem Oszillator während des ersten Teils (A1) der Perioden (21a) zu verbinden und um die Amplitude der Signale, die von der Antenne während wenigstens des zweiten Teils (T) der Perioden (21a) abgestrahlt werden können, zu vermindern.

5. Empfänger nach einem der Ansprüche 1 und 2, **dadurch gekennzeichnet, dass** die Kopplungs-/Entkopplungsmittel einen zwischen die Antenne und den Oszillator-Detektor montierten Filter (39) umfassen, wobei dieser Filter darauf abgestimmt ist, das Minimum an Verlust oder Dämpfung auf der Nominalfrequenz während des ersten Teils (A1) der Perioden (21a) zu zeigen, und Mittel aufweist um auf eine andere Frequenz während des zweiten Teils (T) der Perioden (21a) abgestimmt zu werden und das Maximum an Verlust oder Dämpfung auf der Nominalfrequenz während dieses zweiten Teils (T) zu zeigen.

6. Empfänger nach Anspruch 5, **dadurch gekennzeichnet, dass** der abstimmbare Filter (39) parallel eine Drossel, zwei Dioden mit Variation der Kapazität (41, 42) in Gegenüberstellung und in Reihe, und eine Kapazität (43) umfasst, wobei die Drossel mit der Antenne verbunden ist, der Verbindungspunkt zwischen den Dioden mit den Mitteln (28), welche die ersten und zweiten Teile (28) bestimmen, verbunden ist und die Enden dieses Schaltkreises einerseits mit der Masse und andererseits mit dem Eingang des Oszillator-Detektors verbunden sind.

7. Empfänger nach einem der Ansprüche 1 und 2, **dadurch gekennzeichnet, dass** die Kopplungs-/Entkopplungsmittel zwischen die Antenne (3) und den Oszillator-Detektor (2) geschaltete Verstärkungsmittel (47) und Steuermittel umfassen, um während nur des ersten Teils der Sequenzen diese Verstärkungsmittel arbeiten zu lassen um das von der Antenne eingefangene Signal zu verstärken und dieses verstärkte Signal an den Oszillator-Detektor zu liefern, und um während des zweiten Teils (T) der Perioden (21a) diese Verstärkungsmittel zu trennen.

8. Empfänger nach einem der Ansprüche 1 und 2, **dadurch gekennzeichnet, dass** die Kopplungs-/Entkopplungsmittel Mittel (34, 35, 36) umfassen, um den Oszillator-Detektor bei einer von der Empfangsnominalfrequenz (f1) verschiedenen Hilfsfrequenz (f2) während des zweiten Teils (T) der Perioden (21a) schwingen zu lassen.

9. Empfänger nach Anspruch 8, **dadurch gekennzeichnet, dass** die Kopplungs-/Entkopplungsmittel einen festen Filter (37) umfassen, wie einen Quartzfilter mit einer Durchlassbandbreite, die kleiner ist als jene des Oszillator-Detektors, welcher auf die Empfangsnominalfrequenz (f1) dieses Oszillator-Detektors abgestimmt ist.

10. Empfänger nach Anspruch 9, **dadurch gekennzeichnet, dass** die Kopplungs-/Entkopplungsmittel eine frequenzselektive Antenne umfassen, welche den vorgenannten Filter bildet.

11. Empfänger nach einem der Ansprüche 3 und 6, **dadurch gekennzeichnet, dass** die Kopplungs-/Entkopplungsmittel für das Signal bei der Empfangsnominalfrequenz und dank einem Rückkopplungsschaltkreis einen Dämpferschaltkreis für die Höhe des bei der Nominalfrequenz f1 empfangenen Signals, welches den Oszillator-Detektor erreicht, bildet, welcher in der Amplitude oder Frequenz oder zeitweilig als Funktion der Amplitude des Signals des niederfrequenten Ausgangs steuerbar oder variabel ist, teilweise während des zweiten Teils (A1) der Perioden (21a) übergeht, und auf diese Weise eine automatische Leistungsregelung bildet.

12. Empfänger nach einem der vorherigen Ansprüche, **dadurch gekennzeichnet, dass** die vorgenannten Mittel (28) zum Bestimmen in jeder der Perioden (21a) des Oszillator-Detektors des ersten Teils (A1) gefolgt von dem zweiten Teil (T) einen Monostabilen (28) umfassen, dessen zwei Zustände (A1, T) jeweils diese ersten und zweiten Teile bestimmen.
